(19) Europäisches Patentamt
European Patent Office
Office européen des brevets

(11) **EP 4 310 518 A1**

(12) **EUROPEAN PATENT APPLICATION**
published in accordance with Art. 153(4) EPC

(43) Date of publication:
**24.01.2024 Bulletin 2024/04**

(51) International Patent Classification (IPC):
***G01R 23/165*** (2006.01)

(21) Application number: **22826948.6**

(86) International application number:
**PCT/CN2022/070149**

(22) Date of filing: **04.01.2022**

(87) International publication number:
**WO 2022/267437 (29.12.2022 Gazette 2022/52)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **21.06.2021 CN 202110688450**

(71) Applicants:
• **HEFEI MIDEA HEATING & VENTILATING EQUIPMENT CO., LTD.**
**Boyan Science Park,**
**High-Tech Zone, Hefei**
**Anhui 230088 (CN)**
• **GD Midea Heating & Ventilating Equipment Co., Ltd.**
**Foshan, Guangdong 528311 (CN)**

(72) Inventors:
• **CHEN, Junhua**
**Hefei, Anhui 230088 (CN)**
• **HONG, Weihong**
**Hefei, Anhui 230088 (CN)**
• **WANG, Haohao**
**Hefei, Anhui 230088 (CN)**
• **ZHOU, Chao**
**Hefei, Anhui 230088 (CN)**
• **PENG, Guobin**
**Hefei, Anhui 230088 (CN)**
• **ZHONG, Mingsheng**
**Hefei, Anhui 230088 (CN)**

(74) Representative: **Whitlock, Holly Elizabeth Ann et al**
**Maucher Jenkins**
**Seventh Floor Offices**
**Artillery House**
**11-19 Artillery Row**
**London SW1P 1RT (GB)**

(54) **HARMONIC MEASUREMENT METHOD AND APPARATUS, VARIABLE-FREQUENCY DRIVE AND STORAGE MEDIUM**

(57)     A harmonic measurement method and apparatus (100), a variable-frequency drive (200) and a storage medium. The harmonic measurement method comprises: acquiring a ripple component of a direct-current bus voltage (S101); acquiring a harmonic component of the direct-current bus voltage according to the ripple component (S102); acquiring a quadrature component of the harmonic component according to the harmonic component (S103); acquiring a characteristic parameter of the harmonic component according to the quadrature component, wherein the characteristic parameter comprises phases (S104); and acquiring the voltage amplitude value of the harmonic component according to the phase of the quadrature component and the phase of the harmonic component, and outputting the voltage amplitude value (S 105). By means of the harmonic measurement method, the voltage amplitude value of a harmonic component in a direct-current bus voltage can be effectively measured according to a sampled direct-current bus voltage, the amount of sampling is small, and a calculation process is simple, such that the load of a processor (203) is low, and it is easy to configure a suitable processor (203).

FIG. 1

## Description

The present application claims priority to Chinese Patent Application No. 202110688450.4, titled "METHOD FOR HARMONIC DETECTION AND APPARATUS, FREQUENCY CONVERTER, AND STORAGE MEDIUM", filed with China National Intellectual Property Administration on June 21, 2021, the entire disclosure of which is incorporated herein by reference.

## FIELD

The present disclosure relates to the field of Frequency converter (VFD) technologies, and more particularly, to a method for harmonic detection and apparatus, a frequency converter, and a storage medium.

## BACKGROUND

A typical structure of a frequency converter applied to a three-phase alternating-current motor is an AC-DC-AC variable-frequency system composed of a rectifier, a direct-current bus capacitor, and an inverter. The direct-current bus capacitor serves to store electrical energy to provide a voltage and filter out harmonics. A voltage of the direct current bus capacitor can reflect operation conditions of a power grid, a capacitor, and a load, and therefore can be used as an important index for evaluating an operation state of the system.

In the related art, a commonly used method for harmonic detection for a direct-current bus voltage is to perform mathematical transformation on sampled signals of the direct-current bus voltage through Fourier Transform method. However, the Fourier Transform method relies on a large number of sampled signals and involves a complex calculation process, resulting in a high load for a processor and a difficulty in configuring a suitable processor.

## SUMMARY

One object of embodiments of the present disclosure is to provide a method for harmonic detection and apparatus, a frequency converter, and a storage medium, to solve, in the related art, problems where Fourier Transform method relies on a large number of sampled signals and involves a complex calculation process, resulting in a high load for a processor and a difficulty in configuring a suitable processor.

In order to solve the above technical problems, technical solutions adopted in embodiments of the present disclosure are:

A first aspect of the embodiments of the present disclosure provides a method for harmonic detection . The method for harmonic detection includes: acquiring a ripple component of a direct-current bus voltage; acquiring a harmonic component of the direct-current bus voltage based on the ripple component; acquiring a quadrature component of the harmonic component based on the harmonic component; acquiring a characteristic parameter of the harmonic component based on the quadrature component, the characteristic parameter including a phase; and acquiring and outputting a voltage amplitude of the harmonic component based on the quadrature component and the phase of the harmonic component.

A second aspect of the embodiments of the present disclosure provides a harmonic detection apparatus. The harmonic detection apparatus includes: a ripple component acquisition module configured to acquire a ripple component of a direct-current bus voltage; a harmonic component acquisition module configured to acquire a harmonic component of the direct-current bus voltage based on the ripple component; a quadrature component acquisition module configured to acquire a quadrature component of the harmonic component based on the harmonic component; a characteristic parameter acquisition module configured to acquire a characteristic parameter of the harmonic component based on the quadrature component, the characteristic parameter including a phase; and a voltage amplitude acquisition module configured to acquire and output a voltage amplitude of the harmonic component based on the quadrature component and the phase of the harmonic component.

A third aspect of the embodiments of the present disclosure provides a frequency converter. The frequency converter includes a rectifier configured to be connected to a direct-current bus; an inverter configured to be connected to the direct-current bus and a motor; a memory; a processor; and a computer program stored on the memory and executable on the processor. The processor, when executing the computer program, implements the steps of the method for harmonic detection according to the first aspect of the embodiments of the present disclosure.

A fourth aspect of the embodiments of the present disclosure provides a computer-readable storage medium. The computer-readable storage medium has a computer program stored thereon. The computer program, when executed by a processor, implements the steps of the method for harmonic detection according to the first aspect of the embodiments of the present disclosure.

In the method for harmonic detection according to the first aspect of the embodiments of the present disclosure, a ripple component of a direct-current bus voltage is acquired; a harmonic component of the direct-current bus voltage is acquired based on the ripple component; a quadrature component of the harmonic component is acquired based on the harmonic component; a characteristic parameter of the harmonic component is acquired based on the quadrature component, in which the characteristic parameter includes a phase; and a voltage amplitude of the harmonic component is acquired and outputted based on the quadrature component and the phase of the harmonic component. In this way, the method for harmonic detection can effectively detect the voltage amplitude of the harmonic components in the direct current bus voltage based on the sampled direct current bus voltage. Therefore, sampling quantity is low and a calculation process is simple. Thus, a load for a processor is low, and it is easy to configure a suitable processor.

It should be understood that beneficial effects of the above second aspect to the fourth aspect may refer to the related description in the first aspect, and details thereof are not repeated herein.

## BRIEF DESCRIPTION OF THE DRAWINGS

In order to clearly illustrate technical solutions of embodiments of the present disclosure, drawings used in embodiments are briefly described below. The drawings in the following descriptions are only part embodiments of the present disclosure, and those skilled in the art can obtain other drawings based on these drawings without paying creative labor.

FIG. 1 is a flowchart of a method for harmonic detection according to an embodiment of the present disclosure.
FIG. 2 is a schematic diagram of a frequency response curve of a notch filter according to an embodiment of the present disclosure.
FIG. 3 is a first schematic structural view of a harmonic detection apparatus according to an embodiment of the present disclosure.
FIG. 4 is a second schematic structural view of a harmonic detection apparatus according to an embodiment of the present disclosure.
FIG. 5 is a schematic diagram of a logical structure of a second-order generalized integrator according to an embodiment of the present disclosure.
FIG. 6 is a schematic diagram of a logical structure of a phase-locked loop according to an embodiment of the present disclosure.
FIG. 7 is a schematic diagram of a logical structure of a logic structure of an amplitude feedback regulator according to an embodiment of the present disclosure.
FIG. 8 is a schematic diagram of a frequency converter according to an embodiment of the present disclosure.

## DETAILED DESCRIPTION

In the following description, for illustration and not for limitation, specific details such as particular system structures, techniques, and so on, are provided for a thorough understanding of the embodiments of the present disclosure. However, those skilled in the art would appreciate that the present disclosure can be realized in other embodiments without these specific details. In other cases, detailed descriptions of well-known systems, devices, circuits and methods are omitted to avoid unnecessary details that would impede the description of the present disclosure.

It should be understood that a term "comprise", when used in this specification and appended claims, indicates presence of stated features, integers, steps, operations, elements and/or components, but does not preclude presence or addition of one or more other features, integers, steps, operations, elements, components, and/or groups thereof.

It should also be understood that a term "and/or" used in the description of the present disclosure and the appended claims refers to any combination of one or more of the associated listed items and the possible combinations thereof, and includes these combinations.

As used in this specification and the appended claims, a term "if' may be interpreted, depending on a context, as "when" or "once" or "in response to determining" or "in response to detecting". Similarly, a phrase "if determined" or "if [the described condition or event] is detected" may be interpreted, depending on the context, to mean "once determined" or "in response to determining" or "once [the described condition or event] is detected" or "in response to detecting [the described condition or event]".

In addition, in the description of this specification and the appended claims, terms "first", "second", "third", etc., are used only to distinguish the description and are not to be understood as indicating or implying relative importance.

Reference throughout this specification to "an embodiment," "some embodiments," means that a particular feature, structure, material, or characteristic described in connection with the embodiment is included in one or more embodiments or examples of the present disclosure. Thus, appearances of phrases "in an embodiment," "in some embodiments," or "in some other embodiments," in various places throughout this specification are not necessarily referring to the same embodiment of the present disclosure, but mean "one or more but not all embodiments" unless otherwise specifically emphasized in other manners. Terms "comprise," "include," "have," and variations thereof mean "include, but not limited to," unless otherwise specifically emphasized in other manners.

A method for harmonic detection according to embodiments of the present disclosure provide may be executed by a processor of a frequency converter when running a corresponding computer program for detecting a voltage amplitude and a phase of a harmonic component in a direct-current bus voltage accessed at the frequency converter. During a detection process, sampling quantity is small and a calculation process is simple. Therefore, a load for the processor can be effectively reduced and a configuration difficulty of the processor is reduced.

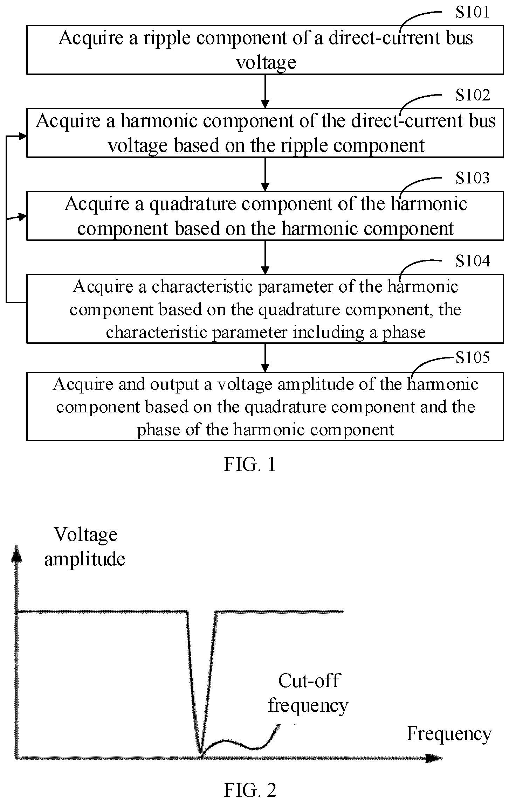

As illustrated in FIG. 1, the method for harmonic detection provided in this embodiment of this application includes actions at blocks S101 to S105.

At block S101, a ripple component of a direct-current bus voltage is acquired.

In application, the direct-current bus voltage in a direct-current bus may be sampled by a voltage sampling module. A sampling cycle may be set to sample in real time or sample once every predetermined time period based on actual needs, and the predetermined duration is a time interval between two adjacent sampling cycles. The voltage sampling module may be an Analog to Digital Converter (ADC).

In one embodiment, the detection method includes, prior to the action at block S101: the direct-current bus voltage is sampled by the voltage sampling module based on the sampling cycle.

In application, the frequency converter may automatically sample a direct-current bus voltage based on a sampling cycle during operation, or may input a sampling instruction through a human-computer interaction component of the frequency converter based on actual needs, or send a sampling instruction to the frequency converter through a user terminal in communication connection with the frequency converter, to control the frequency converter to start sampling the direct current bus voltage.

In application, the human-computer interaction component of the frequency converter may include at least one of a physical button, a touch sensor, a gesture recognition sensor, or a speech recognition unit, and therefore a user can input an instruction in a corresponding touch mode, a gesture control mode, or a speech control mode. The entity button and the touch sensor may be disposed at any position of the frequency converter, for example, a control panel. A specific touch mode of the physical button may be either pressing or toggle. A specific touch mode of the touch sensor may be pressing or tapping, etc. The gesture recognition sensor may be disposed at any position outside a housing of the frequency converter. A gesture for controlling the frequency converter may be customized by a user based on actual needs or may be set to a default when leaving a factory. The speech recognition unit may include a microphone and a speech recognition chip, or may only include the microphone and a speech recognition function is achieved by the processor of the frequency converter. Speech for controlling the frequency converter may be customized by the user based on actual needs or may be set to a default when leaving the factory.

In application, the user terminal may be a mobile phone, a smart wristband, a tablet computer, a notebook computer, a netbook, a Personal Digital Assistant (PDA), a computer, a server, etc., which have wireless or wired communication functions, and can be in communication connection with the frequency converter to realize remote monitoring of harmonic components of a power grid. A specific type of the user terminal in the embodiments of the present disclosure is not limited. The user may control, by means of any human-computer interaction mode supported by the user terminal, the user terminal to send an instruction to the frequency converter. The human-computer interaction mode supported by the user terminal may be the same as those of the frequency converter, and details are not repeated herein. When the frequency converter is applied to an air conditioner, the user terminal may specifically be a computing device applied to a centralized air conditioning control system.

In one embodiment, the action at block S101 includes: obtaining, by a low-pass filter, a direct-current component of the direct-current bus voltage by performing low-pass filtering on the direct-current bus voltage; and obtaining the ripple component of the direct-current bus voltage by acquiring a difference between the direct-current bus voltage and the direct-current component.

In application, the low-pass filtering may be performed on the direct-current bus voltage, and a high-frequency component in the direct-current bus voltage may be removed to obtain a direct-current component containing a low-frequency component. The direct-current bus voltage may be filtered by the low-pass filter, and the low-pass filter may select, based on actual needs, a filter device having a corresponding cut-off frequency, for example, a first-order low-pass filter. The cut-off frequency of the low-pass filter needs to be low enough to ensure that the high-frequency component can be accurately filtered out to obtain the direct-current component.

In one embodiment, an expression of a transfer function of the low pass filter is as follows:

$$H_1 = \omega_{c1}/(s_1 + \omega_{c1})$$

Where $H_1$ represents the transfer function of the low-pass filter, $\omega_{c1}$ represents the cut-off frequency of the low-pass filter, and $s_1$ represents s items of the low-pass filter.

In application, a part of the direct-current bus voltage that removes the direct-current component is the ripple component, and the ripple component may be obtained by calculating the difference between the direct-current bus voltage and the direct-current component. The difference between the direct-current bus voltage and the direct-current component may be calculated by a first subtractor, which may be a differential amplifier.

At block S 102, a harmonic component of the direct-current bus voltage is acquired based on the ripple component.

In application, a harmonic component in the ripple component may be obtained by further filtering the ripple component. A desired arbitrary frequency harmonic component may be obtained by filtering, by a notch filter, the ripple component, e.g., a 2-octave harmonic component and a 6-octave harmonic component.

In one embodiment, the action at block S 102 includes: obtaining a first harmonic component of the direct-current bus voltage by filtering, by a notch filter, the ripple component; and obtaining a second harmonic component of the direct-current bus voltage by acquiring a difference between the ripple component and the first harmonic component.

In application, only a harmonic component of a frequency may be obtained, i.e., the first harmonic component, or harmonic components of two frequencies may also be obtained, i.e., the first harmonic component and the second harmonic component. The first harmonic component and the second harmonic component may be the 2-octave harmonic component and the 6-octave harmonic component, respectively. That is, the 2-octave harmonic component may be first obtained by means of the notch filter, and then a difference between the ripple component and the 2-octave harmonic component is then calculated to obtain the 6-octave harmonic component; or the 6-octave harmonic component may also be obtained by means of the notch filter, and a difference between the ripple component and the 6-octave harmonic component is then calculated to obtain the 6-octave harmonic component. The difference between the ripple component and the first harmonic component may be calculated by a second subtractor, which may be a differential amplifier.

In one embodiment, an expression of a transfer function of the notch filter is as follows:

$$H_2 = (s_2^2 + \omega_{c2}^2)/(s_2^2 + 2 s\omega_{c2}/Q + \omega_{c2}^2)$$

Where $H_2$ represents the transfer function of the notch filter, $\omega_{c2}$ represents a cut-off frequency of the notch filter, $s_2$ represents s items of the notch filter, and Q represents a quality factor of the notch filter.

As illustrated in FIG. 2, a frequency response curve of the notch filter is exemplarily demonstrated, where the cut-off frequency $\omega_{c2}$ of the notch filter is a frequency corresponding to a lowest point of a concavity in the frequency response curve, a steep degree of the concavity in the frequency response curve is determined by the quality factor Q of the notch filter, and a purpose of blocking a specific frequency is achieved by rapidly reducing a gain near the cut-off frequency.

In one embodiment, the harmonic component includes a first harmonic component and a second harmonic component, and the action at block S 102 includes: acquiring, by the notch filter, a first gain in a (k+1)th detection cycle based on a frequency of a second harmonic component in a kth detection cycle, in which k is any positive integer; and obtaining, a first harmonic component of a direct-current bus voltage in the (k+1)th detection cycle by filtering, by the notch filter, a harmonic component of the (k+1)th detection cycle based on the first gain in the (k+1)th detection cycle.

In application, a gain of the notch filter may be set to a fixed value based on actual needs. The kth detection cycle may be a previous detection cycle, the (k+1)th detection cycle may be a current detection cycle, and a gain of the notch filter in the current detection cycle may be calculated based on a frequency of a harmonic component obtained in the previous detection cycle. Similarly, the kth detection cycle may also be a current detection cycle, the (k+1)th detection cycle may also be a next detection cycle, and a gain of the notch filter in the next detection cycle may be calculated based on a frequency of a harmonic component obtained in the current detection cycle. The kth detection cycle covers a kth sampling cycle, i.e., a sampling operation on a direct-current bus voltage in the kth sampling cycle is completed in the kth detection cycle.

At block S103, a quadrature component of the harmonic component is acquired based on the harmonic component.

In application, the quadrature component includes a direct-axis component and a quadrature-axis component, which may be obtained by a second-order generalized integrator. When the harmonic component includes the first harmonic component and the second harmonic component, it is necessary to obtain a quadrature component of the first harmonic component and a quadrature component of the second harmonic component through two second-order generalized integrators, respectively.

In one embodiment, the action at bock S103 includes: acquiring, by a second-order generalized integrator, the quadrature component of the harmonic component based on the harmonic component.

In one embodiment, an expression of a transfer function of the direct-axis component outputted by the second-order generalized integrator is as follows:

$$H_\alpha = k\omega s_\alpha / (s_\alpha{}^2 + k\omega s_\alpha + \omega^2)$$

Where $H_\alpha$ represents the transfer function of the direct-axis component, the direct-axis component and the harmonic component share the same phase, $\omega$ represents an angular velocity of the harmonic component, $s_\alpha$ represents s items of the second-order generalized integrator corresponding to the direct-axis component, and k represents a gain of the second-order generalized integrator.

An expression of a transfer function of the quadrature-axis component outputted by the second-order generalized integrator is as follows:

$$H_\beta = k\omega^2 / (s_\beta{}^2 + k\omega s_\beta + \omega^2)$$

Where $H_\beta$ represents the transfer function of the quadrature-axis component, a phase of the quadrature-axis component lags behind the phase of the harmonic component by 90 degrees, and $s_\beta$ represents s items of the second-order generalized integrator corresponding to the quadrature-axis component.

In application, an angular velocity of the harmonic component is a product of the frequency of the harmonic component and the circumference ratio. Since a frequency of the power grid may change, the frequency of the harmonic component of the direct-current bus voltage will change. Therefore, a frequency of a harmonic component in a current detection cycle is determined by the frequency of the harmonic component acquired in the previous detection cycle, and the frequency of the harmonic component in the next detection cycle is determined by the frequency of the harmonic component acquired in the current detection cycle.

In one embodiment, the action at block S103 includes: acquiring, by a second-order generalized integrator, a second gain in a (k+1)th detection cycle based on a frequency of a harmonic component in a kth detection cycle, wherein k is any positive integer; and acquiring, by the second-order generalized integrator, a quadrature component of a harmonic component in the (k+1)th detection cycle based on the second gain in the (k+1)th detection cycle and a harmonic component in the (k+1)th detection cycle.

In application, a gain of the second-order generalized integrator may be set to a fixed value based on actual needs. The kth detection cycle may be a previous detection cycle, the (k+1)th detection cycle may be a current detection cycle, and a gain of the second-order generalized integrator in the current detection cycle may be calculated based on a frequency of a harmonic component obtained in the previous detection cycle. Similarly, the kth detection cycle may also be a current detection cycle, the (k+1)th detection cycle may also be a next detection cycle, and a gain of the second-order generalized integrator in the next detection cycle may be calculated based on a frequency of a harmonic component obtained in the current detection cycle.

In one embodiment, the harmonic component includes the first harmonic component and the second harmonic component, and the action at block S103 includes: acquiring, by a first second-order generalized integrator, a quadrature component of the first harmonic component based on the first harmonic component; and acquiring, by a second second-order generalized integrator, a quadrature component of the second harmonic component based on the second harmonic component.

In one embodiment, the second gain includes a third gain and a fourth gain, and the action at block S103 includes: acquiring, by a first second-order generalized integrator, a third gain in a (k+1)th detection cycle based on a frequency of a first harmonic component in a kth detection cycle, where k is any positive integer; acquiring, by the first second-order generalized integrator, a quadrature component of a first harmonic component in the (k+1)th detection cycle based on the third gain in the (k+1)th detection cycle and a first harmonic component in the (k+1)th detection cycle; acquiring, by a second second-order generalized integrator, a fourth gain in the (k+1)th detection cycle based on a frequency of a second harmonic component of the kth detection cycle; and acquiring, by the second second-order generalized integrator, a quadrature component of a second harmonic component in the (k+1)th detection cycle based on the fourth gain in the (k+1)th detection cycle and a second harmonic component in the (k +1) th detection cycle.

At block S104, a characteristic parameter of the harmonic component is acquired based on the quadrature component. The characteristic parameter includes a phase.

In application, the characteristic parameter may further include a frequency, and a frequency and a phase of the harmonic component may be acquired by a phase-locked loop. When the harmonic component includes the first harmonic component and the second harmonic component, it is necessary to acquire a frequency and a phase of the first harmonic component and a frequency and a phase of the second harmonic component by the two phase-locked loops, respectively. A frequency of a harmonic component acquired by the phase-locked loop in a current detection cycle may be used to be inputted into the notch filter and the second-order generalized integrator in a next detection cycle to calculate a gain of the notch filter and a gain of the second-order generalized integrator, and a feedback control is performed on the gain of the notch filter and the gain of the second-order generalized integrator to allow for tracking of the frequency of the power grid. The phase may be outputted to the user terminal, and therefore the user terminal may learn a phase of a power grid harmonic, and a curve of a voltage amplitude of the harmonic changing with the phase is then generated based on the phase.

In one embodiment, the action at block S104 includes: acquiring, by the phase-locked loop, a frequency and a phase of the harmonic component based on the quadrature component.

In application, the phase-locked loop is configured to adjust the frequency or the angular velocity of the harmonic component by detecting a q-axis component of the quadrature component. The q-axis component is a representation of a phase error on a voltage, and therefore, the phase error is adjusted to 0 by a proportional integrator (PI) in the phase-locked loop. An output of the proportional integrator is the frequency of the harmonic component, and a change amplitude of the frequency of the harmonic component outputted by the proportional integrator is limited in the phase-locked loop by means of a limiter.

In one embodiment, an expression of the q-axis component of the quadrature component is as follows:

$$U_q = -u_\alpha \sin\theta + u_\beta \cos\theta$$

Where $u_q$ represents the q-axis component, $u_\alpha$ represents a direct-axis component, $u_\beta$ represents a quadrature-axis component, and $\theta$ represents a phase of the q-axis component (i.e., an angle).

In application, the phase of the q-axis component is acquired by converting the frequency of the harmonic component outputted by the phase-locked loop into an angular velocity and integrating the angular velocity.

In one embodiment, the action at block S 104 includes: acquiring, by the phase-locked loop, a frequency and a phase of a harmonic component in a (k+1)th detection cycle based on a phase of a harmonic component in a kth detection cycle and a quadrature component in the (k+1)th detection cycle, wherein k is any positive integer.

In application, the kth detection cycle may be a previous detection cycle, the (k+1)th detection cycle may be a current detection cycle, and a frequency and a phase of a harmonic component in the current detection cycle may be calculated based on a phase of a harmonic component obtained in the previous detection cycle and a quadrature component in the current detection cycle. Similarly, the kth detection cycle may also be a current detection cycle, the (k+1)th detection cycle may also be a next detection cycle, and a frequency and a phase of a harmonic component in the next detection cycle may be calculated based on the phase of the harmonic component obtained in the current detection cycle and a quadrature component in the next detection cycle.

In one embodiment, the harmonic component includes the first harmonic component and the second harmonic component, and the action at block S 104 includes: acquiring, by a first phase-locked loop, a frequency and a phase of the first harmonic component based on the quadrature component of the first harmonic component; and acquiring, by a second phase-locked loop, a frequency and a phase of the second harmonic component based on the quadrature component of the second harmonic component.

In one embodiment, the harmonic component includes the first harmonic component and the second harmonic component, and the action at block S 104 includes: acquiring, a first phase-locked loop, a frequency and a phase of a first harmonic component of a (k+1)th detection cycle based on a phase of a first harmonic component in a kth detection cycle and a quadrature component of a first harmonic component in the (k+1)th detection cycle, where k is any positive integer; and acquiring, by a second phase-locked loop, a frequency and a phase of a second harmonic component in the (k +1) th detection cycle based on a phase of a second harmonic component in the kth detection cycle and a quadrature component of a second harmonic component in the (k+1)th detection cycle.

At block S 105, a voltage amplitude of the harmonic component is acquired and outputted based on the quadrature component and the phase of the harmonic component.

In application, the voltage amplitude of the harmonic component may be acquired by an amplitude feedback regulator, which may be realized by an amplitude-locked loop (MLL). When the harmonic component includes the first harmonic component and the second harmonic component, it is necessary to acquire a voltage amplitude of the first harmonic component and a voltage amplitude of the second harmonic component by two amplitude feedback regulators, respectively. The voltage amplitude may be outputted to the user terminal, and therefore the user terminal evaluates a three-phase imbalance degree of the power grid based on the voltage amplitude.

In one embodiment, the action at block S 105 includes: acquiring and outputting, by an amplitude feedback regulator, the voltage amplitude of the harmonic component based on the quadrature component and the phase of the harmonic component.

In application, the voltage amplitude of the harmonic component may be acquired by dividing a phase outputted by the phase-locked loop by a sine or cosine of a corresponding angle. However, considering that a large calculation error of the voltage amplitude may be caused due to existence of zero-crossing points in sine and cosine signals, the division process in the calculation is eliminated by adopting an amplitude feedback regulator to improve calculation precision of the voltage amplitude. A feedback adjustment of the voltage amplitude in the amplitude feedback regulator is based on the error voltage, and the voltage amplitude is adjusted by the proportional integrator.

In one embodiment, a calculation formula of the error voltage is as follows:

$$U_{err}=(abs(u_{\alpha})-abs(u_{amp}*\cos\theta))+(abs(u_{\beta})-abs(u_{amp}*\sin\theta))$$

Where $U_{err}$ represents the error voltage, abs represents an absolute value symbol, $u_{amp}$ represents the voltage amplitude, $u_{\alpha}$ represents a direct axis component, $u_{\beta}$ represents the quadrature axis component, and $\theta$ represents the phase of the q-axis component.

In one embodiment, the action at block S 105 includes: acquiring and outputting, by the amplitude feedback regulator, a voltage amplitude of a harmonic component in a (k+1)th detection cycle based on a voltage amplitude of a harmonic component in a kth detection cycle, a quadrature component in the (k+1)th detection cycle, and a phase of a harmonic component in the (k+1)th detection cycle, k is any positive integer.

In application, the kth detection cycle may be a previous detection cycle, the (k+1)th detection cycle may be a current detection cycle, and a voltage amplitude of a harmonic component in the current detection cycle may be calculated and outputted based on a voltage amplitude of a harmonic component acquired in the previous detection cycle and a quadrature component and a phase in the current detection cycle. Similarly, the kth detection cycle may also be a current detection cycle, the (k+1)th detection cycle may also be a next detection cycle, and a voltage amplitude of a harmonic component in the next detection cycle may be calculated and outputted based on a voltage amplitude of a harmonic component acquired in the current detection cycle and a quadrature component and a phase in the next detection cycle.

In one embodiment, the harmonic component includes a first harmonic component and a second harmonic component, and the action at block S 105 includes: acquiring and outputting, by a first amplitude feedback regulator, a voltage amplitude of the first harmonic component based on a quadrature component and a phase of the first harmonic component; and acquiring and outputting, by a second amplitude feedback regulator, a voltage amplitude of the second harmonic component based on a quadrature component and a phase of the second harmonic component.

In one embodiment, the harmonic component includes the first harmonic component and the second harmonic component, and the action at block S 105 includes: acquiring and outputting, by a first amplitude feedback regulator, a voltage amplitude of a first harmonic component in the (k+1)th detection cycle based on a voltage amplitude of a first harmonic component in the kth detection cycle, a quadrature component of the first harmonic component in the (k+1)th detection cycle, and a phase of the first harmonic component of the (k+1)th detection cycle, where k is any positive integer; and acquiring and outputting, by a second amplitude feedback regulator, a voltage amplitude of a second harmonic component in the (k+1)th detection cycle based on a voltage amplitude of a second harmonic component in the kth detection cycle, the quadrature component of the second harmonic component in the (k+1)th detection cycle and a phase of the second harmonic component in the (k+1)th detection cycle.

In application, the harmonic component includes a 2-octave harmonic component and a 6-octave harmonic component. The 2-octave harmonic component (i.e., 2 times of a power grid frequency) corresponds to a negative sequence component of a power grid side, and the 6-octave harmonic component (i.e., 6 times of the power grid frequency) corresponds to a positive sequence component of the power grid. A ratio of a voltage amplitude of the 2-octave harmonic component to a voltage amplitude of the 6-octave harmonic component can reflect a proportion of the negative sequence component of the power grid to the positive sequence component of the power grid, that is, it can reflect the three-phase voltage imbalance degree of the power grid. Therefore, after the 2-octave harmonic component and the 6-octave harmonic component are acquired by the user terminal, the three-phase voltage unbalance degree of the power grid can be evaluated by calculating the ratio of the voltage amplitude of the 2-octave harmonic component to the voltage amplitude of the 6-octave harmonic component.

In one embodiment, a calculation formula of the ratio of the voltage amplitude of the 2-octave harmonic component to the voltage amplitude of the 6-octave harmonic component is as follows:

$$K_f=(U_{2nd}/U_{6th})*100\%$$

Where $K_f$ represents the ratio of the voltage amplitude of the 2-octave harmonic component to the voltage amplitude of the 6-octave harmonic component, $U_{2nd}$ represents the voltage amplitude of the 2-octave harmonic component, and $U_{6th}$ represents the voltage amplitude of the 6-octave harmonic component.

In the method for harmonic detection according to the embodiments of the present disclosure, the voltage amplitude of the harmonic component in the direct current bus voltage can be effectively detected based on the sampled direct-current bus voltage. In this way, the sampling quantity is small and the calculation process is simple. Thus, the load for the processor is low, and it is easy to configure the suitable processor. The voltage amplitude of the 2-octave harmonic component and the voltage amplitude of the 6-octave harmonic component are outputted to the user terminal, and therefore the user terminal can evaluate the three-phase voltage unbalance degree of the power grid based on a ratio of the voltage amplitude to the voltage amplitude of the 6-octave harmonic component. Thus, the user can effectively monitor the three-phase voltage imbalance degree of the power grid.

It should be understood that in the above embodiments, numerical values of sequence numbers of the above processes do not mean an execution order and should not constitute any limitation to an implementation process of the embodiments of the present disclosure as the execution order of individual processes should be determined by their functions and internal logics.

The embodiments of the present disclosure further provide a harmonic detection apparatus, which is applied to a frequency converter and configured to perform the method steps in the above method embodiments. The apparatus may be a virtual appliance in the frequency converter, executed by the processor of the frequency converter, or may be the frequency converter itself.

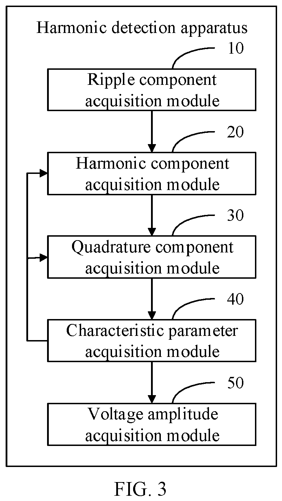

As illustrated in FIG. 3, a harmonic detection apparatus 100 according to the embodiments of the present disclosure includes: a ripple component acquisition module 10 configured to acquire a ripple component of a direct-current bus voltage; a harmonic component acquisition module 20 configured to acquire a harmonic component of the direct-current bus voltage based on the ripple component; a quadrature component acquisition module 30 configured to acquire a quadrature component of the harmonic component based on the harmonic component; a characteristic parameter acquisition module 40 configured to acquire a characteristic parameter of the harmonic component based on the quadrature component, in which the characteristic parameter includes a phase; and a voltage amplitude acquisition module 50 configured to acquire and output a voltage amplitude of the harmonic component based on the quadrature component and the phase of the harmonic component.

In one embodiment, the harmonic detection apparatus 100 further includes: a voltage sampling module configured to sample the direct-current bus voltage based on a sampling cycle.

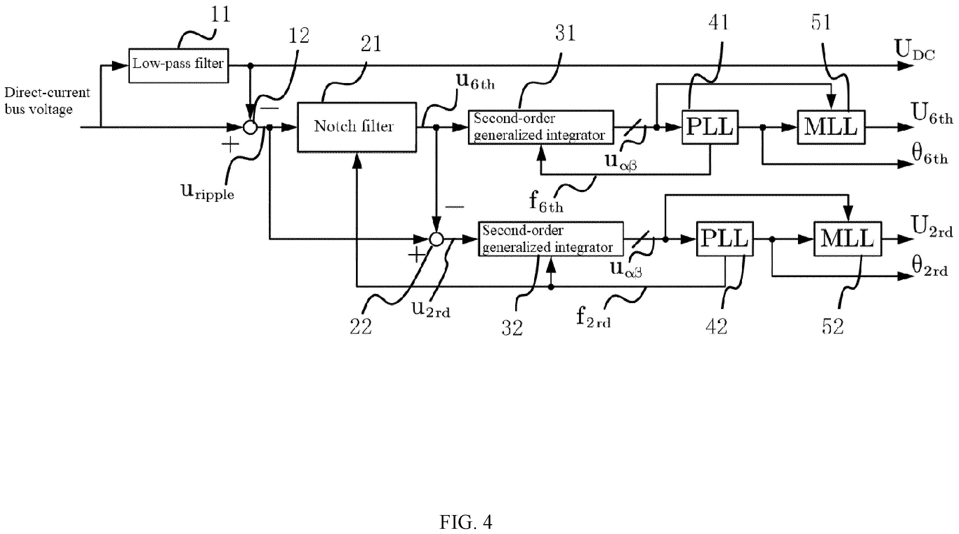

As illustrated in FIG. 4, in one embodiment, the ripple component acquisition module 10 includes: a low-pass filter 11 configured to obtain a direct-current component $U_{DC}$ of the direct-current bus voltage by performing low-pass filtering on the direct-current bus voltage; and a first subtractor 12 configured to obtain a ripple component $u_{ripple}$ of the direct-current bus voltage by acquiring a difference between the direct-current bus voltage and the direct-current component.

In one embodiment, the harmonic component acquisition module 20 includes:

a notch filter 21 configured to obtain a first harmonic component $u_{6th}$ of the direct-current bus voltage by filtering the ripple component; and a second subtractor 22 configured to obtain a second harmonic component $u_{2rd}$ of the direct-current bus voltage by acquiring a difference between the ripple component and the first harmonic component.

In one embodiment, the quadrature component acquisition module 30 includes:

a first second-order generalized integrator 31 configured to acquire a quadrature component $u_{\alpha\beta}$ of the first harmonic component $u_{6th}$ based on the first harmonic component $u_{6th}$; and a second second-order generalized integrator 32 configured to acquire a quadrature component $u_{\alpha\beta}$ of the second harmonic component $u_{2rd}$ based on the second harmonic component $u_{2rd}$.

In one embodiment, the characteristic parameter further includes a frequency, and the characteristic parameter acquisition module 40 includes: a first phase-locked loop 41 configured to acquire a frequency $f_{6th}$ and a phase $\theta_{6th}$ of the first harmonic component $u_{6th}$ based on the quadrature component $u_{\alpha\beta}$ of the first harmonic component $u_{6th}$; and a second phase-locked loop 42 configured to acquire a frequency $f_{2rd}$ and a phase $\theta_{2rd}$ of the second harmonic component $u_{2rd}$ based on the quadrature component $u_{\alpha\beta}$ of the second harmonic component $u_{2rd}$.

In one embodiment, the voltage amplitude acquisition module 50 includes: a first amplitude feedback regulator 51 configured to acquire and output a voltage amplitude $U_{6th}$ of the first harmonic component $u_{6th}$ based on the frequency $f_{6th}$ and the phase $\theta_{6th}$, of the first harmonic component $u_{6th}$; and a second amplitude feedback regulator 52 configured to acquire and output a voltage amplitude $u_{2rd}$ of the second harmonic component $u_{2rd}$ based on the frequency $f_{2rd}$ and the phase $\theta_{2rd}$ of the second harmonic component $u_{2rd}$.

In one embodiment, the characteristic parameter further includes a frequency, and a notch filter 21 is configured to: acquiring a first gain of a (k+1)th detection cycle based on a frequency of a harmonic component in a kth detection cycle, where k is an integer greater than or equal to 1; and acquiring a harmonic component of a direct-current bus voltage in the (k+1)th detection cycle by filtering a harmonic component in the (k +1) th detection cycle based on the first gain in the (k+1)th detection cycle.

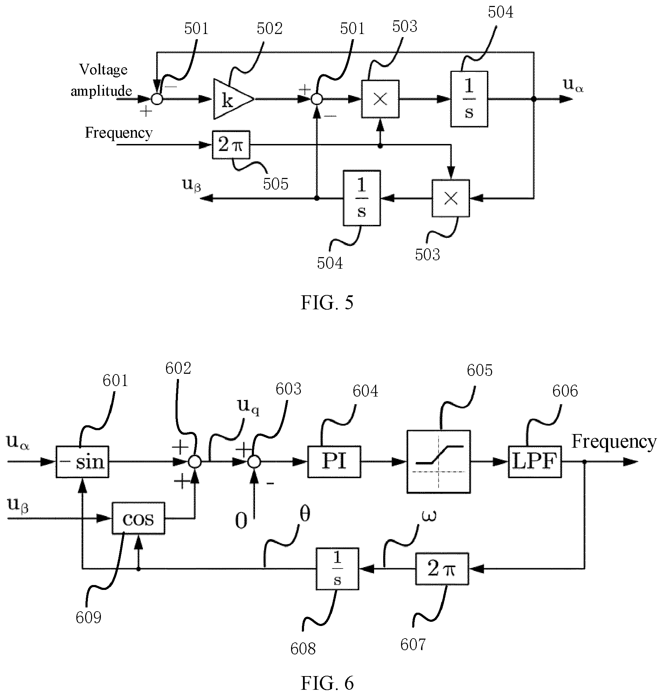

As illustrated in FIG. 5, a logic structure of a second-order generalized integrator is exemplarily demonstrated, which includes two subtractors 501, a gain unit 502, two multipliers 503, two integrators 504, and a constant gain unit 505.

In application, logic structures of the first generalized integrator and the second generalized integrator are identical to the logic structure of the generalized integrator illustrated in FIG. 5. However, a difference lies in that input and output signals of the first generalized integrator correspond to the first harmonic component, and input and output signals of the first generalized integrator correspond to the second harmonic component.

As illustrated in FIG. 6, a logic structure of a phase-locked loop is exemplarily demonstrated, which includes a sine generator (-sin) 601, an adder 602, a subtractor 603, a proportional integrator (PI) 604, an amplitude limiter 605, a low-pass filter (LPF) 606, a constant gain unit (2π) 607, an integrator (1/S) 608, and a cosine generator (cos) 609.

In application, logic structures of the first phase-locked loop and the second phase-locked loop are identical to the logic structure of the phase-locked loop illustrated in FIG. 6. However, a difference lies in that input and output signals of the first phase-locked loop correspond to the first harmonic component, and input and output signals of the second phase-locked loop correspond to the second harmonic component.

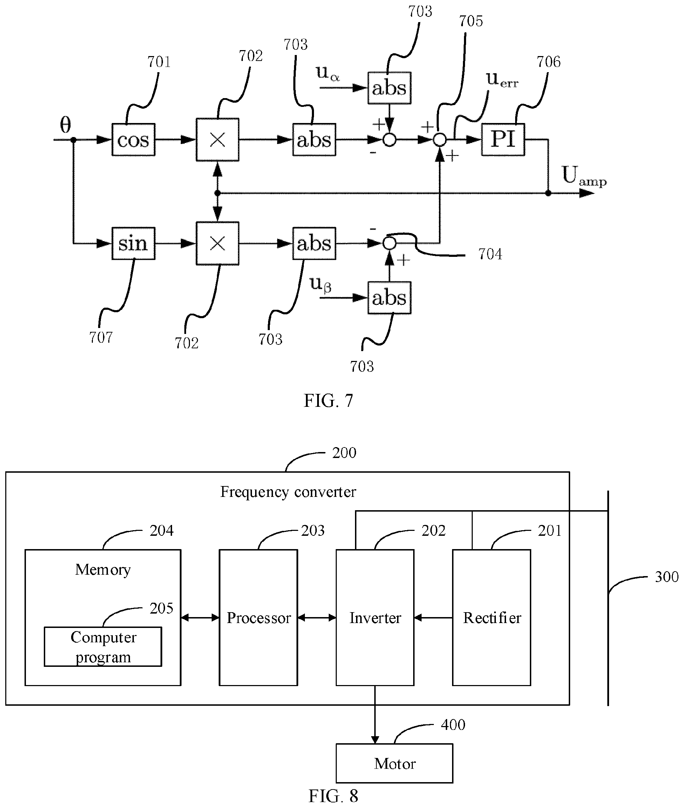

As illustrated in FIG. 7, a logic structure of an amplitude feedback regulator is exemplarily demonstrated, which includes a cosine generator (cos) 701, two multipliers 702, four absolute value units (abs) 703, two subtractors 704, an adder 705, a proportional integrator (PI) 706, and a sine generator (sin) 707.

In application, logic structures of a first amplitude feedback regulator and a second amplitude feedback regulator are identical the logic structure of the amplitude feedback regulator illustrated in FIG. 7. However, a difference lies in that input and output signals of the first amplitude feedback regulator correspond to the first harmonic component, and input and output signals of the second amplitude feedback regulator correspond to the second harmonic component.

In application, each component in the above apparatus may be a software program unit, or may be implemented by different logic circuits integrated in a processor or independent physical components connected to the processor, or may be implemented by a plurality of distributed processors.

As illustrated in FIG. 8, the embodiments of the present disclosure further provide a frequency converter 200. The frequency converter 200 includes: a rectifier 201 configured to be connected to a direct-current bus 300, an inverter 202 configured to be connected to the direct-current bus 300 and a motor 400, at least one processor 203 (only one processor is illustrated in FIG. 8), a memory 204, and a computer program 205 stored on the memory 204 and executable on the at least one processor 203. The processor 202, when executing the computer program 205, implements the steps of the method for harmonic detection according to any one of the above embodiments.

In application, the frequency converter may include, but is not limited to, a collator, an inverter, a processor, and a memory, and may further include an analog-to-digital converter, a low-pass filter, a subtractor, a notch filter, a second-order generalized integrator, a phase-locked loop, an amplitude-locked loop, a subtractor, etc. Those skilled in the art can understand that FIG. 8 is merely an example of the frequency converter, and does not constitute a limitation on the frequency converter. The frequency converter may include more or fewer components than those illustrated in the figures, or combine certain components, or have a different arrangement of components. For example, the frequency converter may further include an input/output device, a network access device, etc. The input/output device may include the above human-computer interaction component, and may further include a display screen configured to display an operation parameter of the frequency converter. The network access device may include a communication module configured to bring the frequency converter into communication with the above user terminal.

In application, the inverter is a device configured to convert a direct-current electrical energy into an alternating current, which may be composed of a three-phase inverter bridge arm, a logic control circuit, and a filter circuit.

In application, the processor may be a Central Processing Unit (CPU), a Network Processor (NP), etc.; and may further be other general-purpose processors, a Digital Signal Processor (DSP), an Application Specific Integrated Circuit (ASIC), a Field-Programmable Gate Array (FPGA) or other programmable logic devices, a discrete gate or a transistor logic device, and a discrete hardware component. The general-purpose processor may be a microprocessor, or the processor may further be any conventional processor, etc.

In application, the memory in some embodiments may be an internal storage unit of the frequency converter, such as a hard disk or a memory of the frequency converter. The memory in other embodiments may also be an external storage device of the frequency converter, for example, a plug-in hard disk, a Smart Media Card (SMC), a Secure Digital (SD) card, a flash card (Flash Card), etc., which are equipped on the frequency converter. The memory may also include both the internal storage unit of the frequency converter and the external storage device of the frequency converter. The memory is configured to store an operating system, an application, a Boot Loader, data, other programs, etc., such as a program code of a computer program. The memory may also be configured to temporarily store data that has been or is about to be outputted.

In application, the display screen may be a Thin Film Transistor Liquid Crystal Display (TFT-LCD), a Liquid Crystal Display (LCD), an Organic Electroluminescent Display (OLED), a Quantum Dot Light Emitting Diode (QLED) display screen, a seven-segment or eight-segment nixie tube, etc.

In application, the communication module may be configured to be any device capable of direct or indirect long-distance wired or wireless communication with a client based on actual needs. For example, the communication module may provide a solution for communication such as a Wireless Local Area Network (WLAN) (such as a Wi-Fi network), Bluetooth, ZigBee, a mobile communication network, a Global Navigation Satellite System (GNSS), a Frequency Modulation (FM), a Near Field Communication (NFC) technology, an Infrared (IR) technology, etc., applied to a network device. The communication module may include an antenna, and the antenna may include only one array element, or may be an antenna array including a plurality of array elements. The communication module may receive an electromagnetic wave via the antenna, perform frequency modulation and filtering processing on an electromagnetic wave signal, and transmit the processed signal into the processor. The communication module may further receive, from the processor, a to-be-transmitted signal, perform frequency modulation and amplification on the signal, and convert the signal into electromagnetic wave radiation via the antenna.

In application, the low-pass filter may select any type of filter with a desired cut-off frequency based on actual needs, such as a Butterworth filter or a Chebyshev filter.

In application, the analog-to-digital converter may select any type of analog-to-digital converter with desired sampling precision based on actual needs, for example, an analog-to-digital converter of a parallel comparison type, a successive approximation type, or a double-integral type. The sampling precision of the analog-to-digital converter is determined by resolution of the analog-to-digital converter, and the resolution may be selected based on actual needs, for example, eight-bit, twelve-bit, or twenty-four bit. When an analog-to-digital converter with switchable resolution is selected, the user can switch the resolution of the analog-to-digital converter through the frequency converter or the human-computer interaction component of the user terminal based on actual needs to adapt to different application scenes.

It should be noted that contents such as information interaction and execution processes between the above apparatuses/modules are based on the same concept as the method embodiments of the present disclosure, and therefore specific functions and technical effects brought by the specific functions may be found in the parts of the method embodiments, and details thereof are not repeated herein.

Those skilled in the art can clearly understand that for convenience and brevity of description, only the division of the above functional modules is used as an example for illustration. In practical applications, the above functions can be assigned to different functional modules as needed. That is, the internal structure of the device is divided into different functional modules to achieve some or all of the functions described above. Each functional module in the embodiments may be integrated in a processing module, or these modules may be separate physical existence, or two or more modules are integrated in a processing module. The above integrated module may be realized in a form of hardware or in a form of software function modules. In addition, the specific names of the functional modules are merely for facilitating mutual differentiation, and are not used to limit the protection scope of the present application. For the specific operation process of the modules in the above system, reference may be made to the corresponding process in the above method embodiments, and details thereof are not repeated herein.

The embodiments of the present disclosure further provide a computer-readable storage medium. The computer-readable storage medium has a computer program stored thereon. The computer program, when executed by the processor, implements the steps in the above method embodiments.

The embodiments of the present disclosure provide a computer program product. The computer program product, when running on a frequency converter, causes the frequency converter to implement the steps in the above method embodiments.

When the integrated module is implemented in the form of the software functional unit and is sold or used as a standalone product, it can be stored in a computer-readable storage medium. Based on this understanding, all or some of the processes in the above method embodiments implemented in the present disclosure, may be completed by instructing related hardware by means of a computer program. The computer program, when executed by a processor, may implement the steps according to any one of the above embodiments. The computer program includes computer program codes that may be in a source code form, an object code form, an executable file, an intermediate form, etc. The computer-readable storage medium at least includes any entity or device capable of carrying computer program codes into the frequency converter, a recording medium, a computer memory, a Read-only Memory (ROM), a Random Access Memory (RAM), an electrical carrier signal, a telecommunication signal, and a software distribution medium, for example, a USB flash disk, a mobile hard disk, a magnetic disk, or an optical disk.

In above embodiments, descriptions of respective embodiments are emphasized differently, and parts that are not detailed in some embodiments can refer to relevant descriptions of other embodiments.

Those skilled in the art could be aware that, exemplary units and algorithm steps described in combination with embodiments disclosed herein may be implemented by electronic hardware, or by a combination of computer software and electronic hardware. Whether these functions are executed by hardware or software is dependent on particular use and design constraints of the technical solutions. Professionals may adopt different methods for different particular uses to implement described functions, which should not be regarded as going beyond the scope of the present disclosure.

In several embodiments provided by the present disclosure, it should be understood that, the disclosed system, device and method may be implemented in other ways. For example, the device embodiments described above are merely illustrative. For example, the units are merely divided according to logic functions, and can be divided in other ways in actual implementation. For example, a plurality of units or components may be combined or may be integrated into another system, or some features may be ignored or not executed. In addition, the mutual coupling or direct coupling or communication connection illustrated or discussed may be via some interfaces, or direct coupling or communication connection of devices or units may be in an electrical, mechanical, or other form.

The units described as separate parts may or may not be physically separated. Parts displayed as units may or may not be physical units, i.e., the parts may be located in one place, or may be distributed on a plurality of network units. Some or all of the units can be selected according to actual needs to achieve purposes of solutions of the embodiments.

The above embodiments are merely used to illustrate the technical solutions of the present disclosure, rather than limiting the technical solutions of the present disclosure. Although the present disclosure has been described in detail with reference to the above embodiments, it should be understood that those skilled in the art can still make modifications to the technical solutions recorded in the above embodiments, or equivalent substitutions of some of the technical features therein. These modifications or substitutions however, do not depart the essence of the corresponding technical solution from the idea and scope of the technical solution of each embodiment of the present disclosure, and shall fall within the protection scope of the present disclosure.

## Claims

1. A method for harmonic detection , comprising:

   acquiring a ripple component of a direct-current bus voltage;
   acquiring a harmonic component of the direct-current bus voltage based on the ripple component;
   acquiring a quadrature component of the harmonic component based on the harmonic component;
   acquiring a characteristic parameter of the harmonic component based on the quadrature component, the characteristic parameter comprising a phase; and
   acquiring and outputting a voltage amplitude of the harmonic component based on the quadrature component and the phase of the harmonic component.

2. The method for harmonic detection according to claim 1, wherein said acquiring the harmonic component of the direct-current bus voltage based on the ripple component comprises:

   obtaining a first harmonic component of the direct-current bus voltage by filtering, by a notch filter, the ripple component;
   obtaining a second harmonic component of the direct-current bus voltage by acquiring a difference between the ripple component and the first harmonic component.

3. The method for harmonic detection according to claim 2, wherein:

   the characteristic parameter further comprises a frequency; and
   said acquiring the harmonic component of the direct-current bus voltage based on the ripple component comprises:

      acquiring, by the notch filter, a first gain in a (k+1)th detection cycle based on a frequency of a second harmonic component in a kth detection cycle, wherein k is any positive integer; and
      obtaining a first harmonic component of a direct-current bus voltage in the (k+1)th detection cycle by filtering, by the notch filter, a harmonic component of the (k+1)th detection cycle based on the first gain in the (k+1)th detection cycle.

4. The method for harmonic detection according to claim 1, wherein said acquiring the quadrature component of the harmonic component based on the harmonic component comprises:
   acquiring, by a second-order generalized integrator, the quadrature component of the harmonic component based on the harmonic component.

5. The method for harmonic detection according to claim 1 or 4, wherein:

the characteristic parameter further comprises a frequency; and
said acquiring the quadrature component of the harmonic component based on the harmonic component comprises:

acquiring, by a second-order generalized integrator, a second gain in a (k+1)th detection cycle based on a frequency of a harmonic component in a kth detection cycle, wherein k is any positive integer; and
acquiring, by the second-order generalized integrator, a quadrature component of a harmonic component in the (k+1)th detection cycle based on the second gain in the (k+1)th detection cycle and the harmonic component in the (k+1)th detection cycle.

6. The method for harmonic detection according to claim 1, wherein said acquiring the characteristic parameter of the harmonic component based on the quadrature component comprises:
acquiring, by a phase-locked loop, the characteristic parameter of the harmonic component based on the quadrature component.

7. The method for harmonic detection according to claim 1 or 6, wherein said acquiring the characteristic parameter of the harmonic component based on the quadrature component comprises:
acquiring, by a phase-locked loop, a characteristic parameter of a harmonic component in a (k+1)th detection cycle based on a phase of a harmonic component in a kth detection cycle and a quadrature component in the (k+1)th detection cycle, wherein k is any positive integer.

8. The method for harmonic detection according to claim 1, wherein said acquiring and outputting the voltage amplitude of the harmonic component based on the quadrature component and the phase of the harmonic component comprises:
acquiring and outputting, by an amplitude feedback regulator, the voltage amplitude of the harmonic component based on the quadrature component and the phase of the harmonic component.

9. The method for harmonic detection according to claim 1 or 8, wherein said acquiring and outputting the voltage amplitude of the harmonic component based on the quadrature component and the phase of the harmonic component comprises:
acquiring and outputting, by an amplitude feedback regulator, a voltage amplitude of a harmonic component in a (k+1)th detection cycle based on a voltage amplitude of a harmonic component in a kth detection cycle, a quadrature component in the (k+1)th detection cycle, and a phase of the harmonic component in the (k+1)th detection cycle, wherein k is any positive integer.

10. A harmonic detection apparatus, comprising:

a ripple component acquisition module configured to acquire a ripple component of a direct-current bus voltage;
a harmonic component acquisition module configured to acquire a harmonic component of the direct-current bus voltage based on the ripple component;
a quadrature component acquisition module configured to acquire a quadrature component of the harmonic component based on the harmonic component;
a characteristic parameter acquisition module configured to acquire a characteristic parameter of the harmonic component based on the quadrature component, the characteristic parameter comprising a phase; and
a voltage amplitude acquisition module configured to acquire and output a voltage amplitude of the harmonic component based on the quadrature component and the phase of the harmonic component.

11. A frequency converter, comprising:

a rectifier configured to be connected to a direct-current bus;
an inverter configured to be connected to the direct-current bus and a motor;
a memory;
a processor; and
a computer program stored on the memory and executable on the processor,
wherein the processor, when executing the computer program, implements the steps of the method for harmonic detection according to any one of claims 1 to 9.

12. A computer-readable storage medium, having a computer program stored thereon, wherein the computer program, when executed by a processor, implements the steps of the method for harmonic detection according to any one of claims 1 to 9.

Acquire a ripple component of a direct-current bus voltage — S101

Acquire a harmonic component of the direct-current bus voltage based on the ripple component — S102

Acquire a quadrature component of the harmonic component based on the harmonic component — S103

Acquire a characteristic parameter of the harmonic component based on the quadrature component, the characteristic parameter including a phase — S104

Acquire and output a voltage amplitude of the harmonic component based on the quadrature component and the phase of the harmonic component — S105

FIG. 1

Voltage amplitude

Cut-off frequency

Frequency

FIG. 2

Harmonic detection apparatus

— 10

Ripple component
acquisition module

— 20

Harmonic component
acquisition module

— 30

Quadrature component
acquisition module

— 40

Characteristic parameter
acquisition module

— 50

Voltage amplitude
acquisition module

FIG. 3

FIG. 4

EP 4 310 518 A1

FIG. 5

FIG. 6

FIG. 7

FIG. 8

## INTERNATIONAL SEARCH REPORT

| International application No. |
|---|
| **PCT/CN2022/070149** |

**A. CLASSIFICATION OF SUBJECT MATTER**

G01R 23/165(2006.01)i

According to International Patent Classification (IPC) or to both national classification and IPC

**B. FIELDS SEARCHED**

Minimum documentation searched (classification system followed by classification symbols)

G01R 23/-

Documentation searched other than minimum documentation to the extent that such documents are included in the fields searched

Electronic data base consulted during the international search (name of data base and, where practicable, search terms used)

CNPAT, WPI, EPODOC, CNKI, USTXT, EPTXT, WOTXT: 合肥美的暖通设备有限公司, 广东美的暖通设备有限公司, 陈俊桦, 洪伟鸿, 王豪浩, 周超, 彭国彬, 钟明胜, 谐波, 直流, 电压, 纹波, 滤波, 积分, 正交, 锁相, 频率, 幅值, 相位, harmonic, direct, voltage, ripple, filter, integrator, orthogonal, lock+, frequency, amplitude, phase

**C. DOCUMENTS CONSIDERED TO BE RELEVANT**

| Category* | Citation of document, with indication, where appropriate, of the relevant passages | Relevant to claim No. |
|---|---|---|
| PX | CN 113341226 A (HEFEI MIDEA HEATING & VENTILATING EQUIPMENT CO., LTD. et al.) 03 September 2021 (2021-09-03) <br> claims 1-12, description paragraphs [0004]-[0178], figures 1-8 | 1-12 |
| E | CN 114024450 A (HEFEI MIDEA HEATING & VENTILATING EQUIPMENT CO., LTD. et al.) 08 February 2022 (2022-02-08) <br> description, paragraphs [0005]-[0158], and figures 1-6 | 1, 4, 6, 8, 10-12 |
| A | CN 205091391 U (WUXI POWER SUPPLY COMPANY OF JIANGSU ELECTRIC POWER COMPANY et al.) 16 March 2016 (2016-03-16) <br> description, paragraphs [0009]-[0011], and figures 1-2 | 1-12 |
| A | CN 105141144 A (SHANGHAI STEP ELECTRIC CORPORATION et al.) 09 December 2015 (2015-12-09) <br> entire document | 1-12 |
| A | CN 106405236 A (CHINA UNIVERSITY OF GEOSCIENCES, WUHAN) 15 February 2017 (2017-02-15) <br> entire document | 1-12 |

☑ Further documents are listed in the continuation of Box C.    ☑ See patent family annex.

| | |
|---|---|
| \*   Special categories of cited documents: <br> "A"   document defining the general state of the art which is not considered to be of particular relevance <br> "E"   earlier application or patent but published on or after the international filing date <br> "L"   document which may throw doubts on priority claim(s) or which is cited to establish the publication date of another citation or other special reason (as specified) <br> "O"   document referring to an oral disclosure, use, exhibition or other means <br> "P"   document published prior to the international filing date but later than the priority date claimed | "T"   later document published after the international filing date or priority date and not in conflict with the application but cited to understand the principle or theory underlying the invention <br> "X"   document of particular relevance; the claimed invention cannot be considered novel or cannot be considered to involve an inventive step when the document is taken alone <br> "Y"   document of particular relevance; the claimed invention cannot be considered to involve an inventive step when the document is combined with one or more other such documents, such combination being obvious to a person skilled in the art <br> "&"   document member of the same patent family |

| Date of the actual completion of the international search | Date of mailing of the international search report |
|---|---|
| **14 March 2022** | **29 March 2022** |

| Name and mailing address of the ISA/CN | Authorized officer |
|---|---|
| **China National Intellectual Property Administration (ISA/ CN)** <br> **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

## INTERNATIONAL SEARCH REPORT

International application No.

**PCT/CN2022/070149**

### C. DOCUMENTS CONSIDERED TO BE RELEVANT

| Category* | Citation of document, with indication, where appropriate, of the relevant passages | Relevant to claim No. |
|---|---|---|
| A | CN 101587146 A (HUNAN UNIVERSITY) 25 November 2009 (2009-11-25)<br>entire document | 1-12 |
| A | CN 112701932 A (QINGDAO TOPSCOMM COMMUNICATION CO., LTD.) 23 April 2021 (2021-04-23)<br>entire document | 1-12 |
| A | US 2014333247 A1 (SEAGATE TECHNOLOGY LLC) 13 November 2014 (2014-11-13)<br>entire document | 1-12 |

Form PCT/ISA/210 (second sheet) (January 2015)

**INTERNATIONAL SEARCH REPORT**
**Information on patent family members**

International application No.

**PCT/CN2022/070149**

| Patent document cited in search report | | | Publication date (day/month/year) | Patent family member(s) | | | Publication date (day/month/year) |
|---|---|---|---|---|---|---|---|
| CN | 113341226 | A | 03 September 2021 | None | | | |
| CN | 114024450 | A | 08 February 2022 | None | | | |
| CN | 205091391 | U | 16 March 2016 | None | | | |
| CN | 105141144 | A | 09 December 2015 | CN | 105141144 | B | 14 November 2017 |
| CN | 106405236 | A | 15 February 2017 | None | | | |
| CN | 101587146 | A | 25 November 2009 | CN | 101587146 | B | 27 April 2011 |
| CN | 112701932 | A | 23 April 2021 | None | | | |
| US | 2014333247 | A1 | 13 November 2014 | None | | | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202110688450